# EUROPEAN PATENT SPECIFICATION

(11) **EP 1 585 789 B1**
(45) Date of publication and mention of the grant of the patent: **08.11.2017**
(21) Application number: 04704064.7
(22) Date of filing: 21.01.2004
(51) Int. Cl.: B32B 27/30, C08K 3/22, C04B 24/26, C08L 31/04, C08K 3/08, C08L 23/08, C08L 33/04, C08L 67/00, C08L 67/02, C08L 101/12, G01P 3/44, G01P 3/487, H03M 1/24

(54) **MAGNETIZABLE THERMOPLASTIC ELASTOMERS**
MANGETISIERBARE THERMOPLASTISCHE ELASTOMERE
ELASTOMERES THERMOPLASTIQUES MAGNETISABLES

(30) Priority: 23.01.2003 US 442572 P; 28.04.2003 US 424642
(43) Date of publication of application: 19.10.2005
(73) Proprietor: Carl Freudenberg KG, 69469 Weinheim (DE)
(72) Inventor: NACHTIGAL, Daniel, Jamaica Plain, MA 02130 (US); CHMIELEWSKI, Craig, Shelby Township, MI 48315 (US)
(74) Representative: Mattausch, Klaus
(86) International application number: PCT/US2004/001540
(87) International publication number: WO 2004/065476

(56) References cited:
- WO-A-01/85827
- SU-A1- 642 336
- US-A1- 2002 183 427
- US-B1- 6 500 374
- US-B1- 6 500 374
- US-B2- 6 774 171
- US-B2- 6 872 325
- US-B2- 6 939 477

## Description

### INTRODUCTION

This invention relates to magnetizable thermoplastic elastomers, and to the application of such elastomers in use with magnetic speed sensor targets (encoders).

Rotational speed sensors, such as those used in automotive applications, have generally been based on principles of magnetic field sensing. Targets for speed sensors, such as magnetic encoders, generally have a magnetizable substance bonded to a structural support ring with alternating magnetic poles established around the circumference of the magnetizable substance. Thermoset elastomers have been used as carriers for ferrite poweders, to provide adequate mechanical, dynamic and thermal behavior needed in press-fit conditions common in automotive wheel-speed applications. However, thermoset elastomer-based magnetic compounds are difficult to blend in production-sized rubber compounding equipment due to their high density from the loading level of ferrite. In this regard, production batch volumes weigh two to four times more than standard rubber compound batches, and handling of the material is thereby difficult. Processing of thermoset elastomer-based magnetic compounds also requires relatively expensive equipment, substantial time, and substantial labor to manufacture a fully cured article.

Thermoplastic elastomers are a potential replacement for thermoset rubbers in magnetizable compounds for encoders, but material properties respective to durability limit their potential use. In this regard, commercially available thermoplastic elastomers, when loaded with magnetizable ferrite, show substantial loss of elongation in extreme thermal conditions; durability is therefore diminished in applications such as automotive rotational speed sensors. Thermoplastic-elastomer-based magnetic encoders having loadings of about fifty percent strontium ferrite perform acceptably under certain conditions, but such encoders are generally too brittle for broad use in this type of application, especially in comparison to thermoset based encoders with a metal particle loading. For example, an encoder employed in an automotive application may have an operating temperature range of - 40°C to 125°C. To attain highly magnetizable compounds useful for magnetic speed-sensor targets, volumetric loading of ferrite in the compound preferably exceeds twenty five percent. Attempts to employ engineered thermoplastics as carriers for the magnetic ferrite in order to produce magnetic materials at these loadings have been unsuccessful insofar as the engineered thermoplastics are very brittle and difficult to handle. Moreover, the engineered thermoplastics do not demonstrate static, dynamic, and thermal durability sufficient for magnetic encoder use. Another issue of concern in use of thermoplastic-elastomer-based magnetic compounds is that material expansion and contraction due to thermal conditions often leads to stress cracking - particularly a problem when the magnetic compound is mated to a support member with a dissimilar thermal expansion coefficient. Such mated structural materials may include, for example, stainless steel or sintered iron. Consequently, engineered thermoplastics with high ferrite powder loading have not been available which are capable of withstanding weeks-long continuous operation at the elevated temperatures and other conditions required of magnetic encoders.

Thus, it is desirable to have a magnetizable material that may be readily fabricated into a magnetic encoder while maintaining the desired properties in use of the magnetic encoder.

### SUMMARY

The invention provides a magnetizable thermoplastic elastomer composition as an admixture of thermoplastic polymer, elastomeric polymer, and magnetizable powder, wherein the thermoplastic polymer is thermoplastic elastomer and the elastomeric polymer is thermoset elastomer.

In one embodiment of the invention, the admixture has a first phase and a second phase where
(a) the first phase comprises a thermoplastic polymeric material;
(b) the second phase comprises a cured elastomeric polymeric material; and
(c) the magnetizable powder is dispersed in the first phase and in the second phase.

The invention also provides an encoder of
(a) a magnetic sensor adapted to detect changes in an adjacent magnetic field; and
(b) a target wheel having a surface adjacent to the magnetic sensor and movable relative thereto, where the target wheel is made of thermoplastic polymer (such as thermoplastic elastomer), cured elastomeric polymeric material (such as thermoset elastomer), and magnetizable powder, and where the target wheel is magnetized to provide alternating magnetic polarity along the surface and, in operation, the magnetic field changes.

In one embodiment, the invention provides a target wheel for use in an encoder comprising a generally disk shaped member which is made of an admixture of thermoplastic polymer (thermoplastic elastomer), cured elastomeric polymeric material (thermoset elastomer), and magnetizable powder.

The invention also provides a method of making an magnetizable thermoplastic elastomer composition by admixing thermoplastic polymer (thermoplastic elastomer), cured elastomeric polymeric material (thermoset elastomer), and magnetizable powder. In one embodiment, the invention comprises dynamically vulcanizing the elastomeric polymeric material in the magnetizable elastomeric material.

The magnetizable thermoplastic elastomer compositions and method of this invention afford one or more benefits over compositions and methods among those known in the art, including mechanical and durability advantages of thermoset elastomer-based magnetic compounds, under the range of conditions needed for vehicle encoder applications, with the processing and manufacturing advantages of engineered thermoplastics. Further areas of applicability will become apparent from the detailed description provided hereinafter. It should be understood that the detailed description and specific examples, while indicating embodiments of the invention, are intended for purposes of illustration only and are not intended to limit the scope of the invention.

### BRIEF DESCRIPTION OF DRAWINGS

Fig. 1 is a cross sectional view of an encoder assembly;
Fig. 2 is a plan view of another embodiment of a sensor target assembly;
Fig. 3 is a partial cross section taken along line A-A in Fig. 2;
Fig. 4 is a cross sectional view of another embodiment of a sensor target assembly; and
Fig. 5 illustrates an embodiment of a method for making the compositions of the invention.

It should be noted that the figures set forth herein are intended to exemplify the general characteristics of an apparatus, materials and methods among those of this invention, for the purpose of the description of such embodiments herein. These figures may not precisely reflect the characteristics of any given embodiment, and are not necessarily intended to define or limit specific embodiments within the scope of this invention.

### DESCRIPTION

The following definitions and non-limiting guidelines must be considered in reviewing the description of this invention set forth herein.

The headings (such as "Introduction" and "Summary") used herein are intended only for general organization of topics within the disclosure of the invention, and are not intended to limit the disclosure of the invention or any aspect thereof. In particular, subject matter disclosed in the "Introduction" may include aspects of technology within the scope of the invention, and may not constitute a recitation of prior art. Subject matter disclosed in the "Summary" is not an exhaustive or complete disclosure of the entire scope of the invention or any embodiments thereof.

The citation of references herein does not constitute an admission that those references are prior art or have any relevance to the patentability of the invention disclosed herein.

The description and specific examples, while indicating embodiments of the invention, are intended for purposes of illustration only and are not intended to limit the scope of the invention. Moreover, recitation of multiple embodiments having stated features is not intended to exclude other embodiments having additional features, or other embodiments incorporating different combinations of the stated features.

As used herein, the words "preferred" and "preferably" refer to embodiments of the invention that afford certain benefits, under certain circumstances. However, other embodiments may also be preferred, under the same or other circumstances. Furthermore, the recitation of one or more preferred embodiments does not imply that other embodiments are not useful, and is not intended to exclude other embodiments from the scope of the invention.

As used herein, the word 'include," and its variants, is intended to be non-limiting, such that recitation of items in a list is not to the exclusion of other like items that may also be useful in the materials, compositions, devices, and methods of this invention.

In one embodiment, a blended admixture is provided of thermoplastic elastomers (TPE), thermoset elastomers in a non-vulcanized state, and magnetizable ferrite powder. Preferably, such admixtures produce flexible and magnetizable thermoplastic elastomer compositions that are fully thermoplastic in nature. In various embodiments, by blending certain amounts of desired ingredients, these thermoplastic materials can be melt-processed in standard processing equipment, such as injection molders, plastic extruders and blow molders, and yet still maintain material properties needed for use in magnetic encoders. In one embodiment, such materials are used in magnetic encoders employed under the extreme environmental conditions experienced by automotive vehicles.

Some compositional embodiments incorporate non-cured ethylene acrylic (AEM) elastomers or rubber copolymers of an acrylate and a cross-linking monomer (ACM) at desired amounts, preferably such that, even at the ferrite powder levels needed for magnetizable encoders, the material is strong and flexible enough to produce robust parts.

An advantage of various embodiments is provided insofar as the thermoset rubber is preferably maintained in a non-cured state, which in turn provides both the thermoplastic and thermoset phases of the blended material as carriers for the magnetizable ferrite. This preferably provides for high volumetric loading of the ferrite powder even as desired material properties are essentially sustained.

Moreover, the addition of non-cured rubber at the noted amounts in the embodiments preferably does not compromise processability. In this regard, the admixtures are easily processed, for example, by continuous compounding through twin-screw extrusion, fragmentation into small pellets for ease of handling through cutting, and then fabrication into components using established thermoplastic processing equipment.

In one embodiment, a thermoplastic polyester elastomer (TPE) material is blended with a thermoset elastomer, preferably in a non-vulcanized state, and with magnetizable ferrite powder to produce a flexible and magnetizable thermoplastic elastomer compound that is preferably essentially fully thermoplastic in nature. As such, the magnetizable thermoplastic elastomer compound is then preferably processed with conventional techniques employed with TPE materials and still produce desirable material characteristics, even with the loading of magnetizable powder needed for magnetic field provision.

Thermoplastic elastomers are a class of polymers in which the end use properties of vulcanized elastomers are combined with the processing advantages of thermoplastics. They allow for conventional processing techniques, such as milling, injection molding, extrusion, blow molding, and vacuum forming - allowing the production of useful articles having true elastomeric properties without compounding or vulcanization.

An example of a TPE that can be advantageously employed in the embodiments is Hytrel™ thermoplastic polyester elastomer, sold by Dupont. Examples of thermoset elastomers useful in the embodiments include ethylene acrylic elastomers (AEM), such as Vamac™ G, sold by Dupont. The AEM elastomers can be used as "solid plasticizers" to toughen, i.e., increase elongation and decrease tensile strength of the TPE compounds, but without sacrificed of heat aging performance. In an alternative embodiment, copolymers of acrylate and cross-linking monomer (ACM) elastomers are employed instead of AEM elastomers to "plasticize" TPE based compounds; examples of ACMs include Nypol™ and Hytemp™ as sold by Zeon and Noxtite™ as sold by Unimatec.

The present compositions comprise a hard magnetic material, such as magnetizable powder, including such powders that are known in the art. The hard magnetic materials used in the embodiments are preferably those materials that are ferromagnetic but retain their crystal structure once a magnetic field is applied. They are materials used to form permanent magnets. As such, they strongly resist demagnetization once they are magnetized. In general, such materials are known, and exhibit coercivities Hc of from about 10 to about 100 kA/m, where A/m represents an oersted unit. It should be noted that, in some cases, the materials exhibit coercivities Hc of above 100 kA/m. In various embodiments, the magnetizable powder is selected from the group consisting of magnetizable ferrites (such as strontium-ferrite oxide and barium-ferrite oxide), ferrite alloys (such as those containing aluminum and nickel and cobalt), rare-earth ferrite granulates; and mixtures thereof. An example of a suitable ferrite alloy containing aluminum and nickel and cobalt is Alnico™ (available from MMC Magnetics of Hauppauge, New York).

Barium-ferrite has a nominal structure of BaO.6Fe2O3, while strontium ferrite is given as SrO.6Fe2O3. Alnico™ ferrites are iron alloys containing aluminum, nickel and cobalt, as well as other optional metals. Specific examples include Alnico™ 3, Alnico 8, and Alnico 9. The listed Alnico ferrites contain from about 34 to about 50% iron, from about 24 to about 35% cobalt, about 15% nickel, and from about 7 to about 8% aluminum, the percentages being based on the total weight of the alloy. Other hard materials include iron alloys having atomic formulas Fe65Cr32Co3 and Fe63Cr25Co12. A cobalt-samarium alloy of atomic formula Co5Sm is also available.

Elongated single domain (ESD) Fe-Co material is also available as a hard magnetic material. It is an alloy containing about 9.9% iron Fe, about 5.5% Co, about 77% Pb, and about 8.6% Sn, the percentages being based on the total weight of the alloy. Other known alloys having hard magnetic properties useful for formulating the magnetizable composition embodiments include Mn-Al-C (70 wt. % Mn, 29 wt. % Al, 0.5 wt. % Ni, 0.5 wt. % C), Co-Pt (77 wt. % Pt, 23 wt. % Co) and Fe-Nd-B (66 wt. % Fe, 33 wt. % Nd, and 1 wt. % B).

A range of loadings for the magnetizable thermoplastic elastomer compound components provides useful embodiments for encoder and similar applications. The blending of non-vulcanized (non-cured) thermoset elastomer, at a ratio of from about 25% to about 75% (by weight), to the thermoplastic elastomer carrier provides extended operating temperature durability without compromising processability and magnetic performance. The magnetizable material is then added to this blend, at a level of from about 1% to about 90%, optionally at a level of from about 70% to about 90% (by weight). For sufficient magnetic strength, depending upon the volumetric ferrite loading needed for the application of the magnetizable thermoplastic elastomer compound, the composition comprises magnetizable powder at a level of from about 25% to 70%, optionally from about 30% to about 67%, optionally from about 40% to about 60% (by volume). Preferably the level of the magnetizable powder affords good processability, material strength and durability.

In a multiphase embodiment having cured (or vulcanized) elastomeric phases blended with thermoplastic phases, magnetizable compositions contain two blended polymeric phases wherein magnetizable particles of a hard magnetic material are dispersed in both polymeric phases. A first polymeric phase is made of a thermoplastic polymeric material, and the second polymeric phase contains a cured elastomeric polymeric material. The elastomeric polymeric material may be fully cured or partially cured. While providing a heterogeneous blend in a detailed sense, the blended phases are preferably of sufficiently small individual phase domains so that an overall homogeneous blend is superficially indicated.

The multiphase embodiment compositions are relatively heavily loaded with a hard magnetic material type of magnetic powder to provide compositions that can be formed into encoders and targets for rotational sensors that operate on magnetic principles. In particular, shaped articles produced from the magnetizable composition embodiments may be magnetized according to known procedures to produce alternating opposite magnetic poles along a surface of the shaped article.

The thermoplastic material and the cured elastomeric material are present in the magnetizable composition embodiments at levels sufficient to provide the necessary material and strength and durability for the application, while retaining good processability on standard plastics equipment. If the weight level of thermoplastic material is taken as 100, the level of the cured elastomeric material can generally range from about 10 to about 300. Preferably, the elastomeric material level is at 25. In another preferred embodiment, the level of elastomeric material is at least about 50. That is, the ratio of cured elastomeric material to thermoplastic material in the composition embodiments ranges from about 1:10 to about 3:1. In a preferred embodiment, the cured elastomeric material is present relatively to the thermoplastic material at a rate ratio of about 1:1 or less. Preferably, the ratio of elastomeric material to thermoplastic material is at least about 1:4. In another preferred embodiment, the elastomeric material is present at from about 50% to about 75% that of the thermoplastic material.

In a preferred multiphase embodiment, the cured elastomeric material is present as particles dispersed in a continuous thermoplastic material phase. Thus, it is preferred to provide the elastomeric material and the thermoplastic material in such a ratio that a continuous phase of thermoplastic material is produced in the blend. No matter the structure of the elastomeric and thermoplastic phases, the hard magnetic material is preferably evenly distributed in both phases. Incorporation of the hard magnetic material into both the cured elastomeric phase and the thermoplastic phase is accomplished by mixing the thermoplastic material, the hard magnetic material, and the elastomeric material in an uncured state for a time sufficient to disperse the magnetic material in both phases prior to a subsequent curing step, discussed further below.

In a preferred embodiment, the thermoplastic polymeric material used in the embodiments may be a thermoplastic elastomer (TPE). As previously noted, thermoplastic elastomers have some physical properties of rubber, such as softness, flexibility and resilience, but may be processed like thermoplastics. A transition from a melt to a solid rubber-like composition occurs fairly rapidly upon cooling. The transition is readily reversible upon heating. This is in contrast to conventional elastomers, which harden slowly (and generally irreversibly) upon heating. Thermoplastic elastomers may be processed on conventional plastic equipment such as injection molders and extruders. Scrap may generally be readily recycled.

Thermoplastic elastomers have a multi-phase structure, wherein the phases are generally intimately mixed. In many cases, the phases are held together by graft or block copolymerization. At least one phase is made of a material that is hard at room temperature but fluid upon heating. Another phase is a softer material that is rubber like at room temperature. It is common to refer to the hard phase as "crystalline" and to the soft phase as "amorphous".

Many thermoplastic elastomers are known. They in general adapt either the A-B-A triblock structure or the (A-B)n repeating structure, where A represents hard segments and B is a soft segment. Because most polymeric materials tend to be incompatible with one another, the hard and soft segments of thermoplastic elastomers tend to associate with one another to form hard and soft phases. For example, the hard segments tend to form spherical regions or domains dispersed in a continuous elastomer phase. At room temperature, the domains are hard and act as physical crosslinks tying together elastomeric chains in a 3-D network. The domains tend to lose strength when the material is heated or dissolved in a solvent. Among the most common commercially available thermoplastic elastomers are those that contain polystyrene as the hard segment.

Non-limiting examples of A-B-A type thermoplastic elastomers include polystyrene/polysiloxane/polystyrene, polystyrene/polyethylene-co-butylene/polystyrene, polystyrene/polybutadiene polystyrene, polystyrene/polyisoprene/polystyrene, poly-α-methylstyrene/polybutadiene/ poly-α-methyl styrene, poly-α-methyl styrene/polyisoprene/ poly-α-methyl styrene, and polyethylene/polyethylene-co-butylene/polyethylene. Triblock elastomers are available with polystyrene as the hard segment and either polybutadiene, polyisoprene, or polyethylene-co-butylene as the soft segment.

Non-limiting examples of thermoplastic elastomers having a (A-B)n repeating structure include polyamide/polyether, polysulfone/polydimethylsiloxane, polyurethane/polyester, polyurethane/poly-ether, polyester/polyether, polycarbonate/ polydimethylsiloxane, and polycarbonate/polyether. Similarly, styrene butadiene repeating co-polymers are commercially available, as well as polystyrene/polyisoprene repeating polymers.

In a preferred embodiment, a polyester thermoplastic elastomer is used to make the magnetizable composition embodiments. Such thermoplastic elastomers are generally (A-B)n type block copolymers. In one embodiment, the hard segment is made of a polyester structure formed from diacids and low molecular weight diols such as ethylene glycol and butylene. The soft segment is made of a polyester structure based on long chain polyether glycols. Polyester TPEs (such as aforementioned Hytrel™) have some rubber like properties, but may be readily formed into parts by a variety of thermoplastic processing techniques. They exhibit good toughness, resilience, resistance to creep, impact and flex fatigue, low temperature flexibility, retention of properties at elevated temperatures, and dynamic properties.

The thermoplastic polymeric material may also be selected from among solid, generally high molecular weight, plastic materials. Preferably, the materials are crystalline or semi-crystalline polymers, and more preferably have a crystallinity of at least 25 percent as measured by differential scanning calorimetry. Polymers with a high glass transition temperature are also acceptable as the thermoplastic polymeric material. The thermoplastic also preferably has a melt temperature or glass transition temperature in the range from about 80oC to about 350oC, but the melt temperature should preferably be lower than the decomposition temperature of the thermoplastic vulcanizate.

Non-limiting examples of thermoplastic polymers include polyolefins, polyesters, nylons, polycarbonates, styrene-acrylonitrile copolymers, polyethylene terephthalate, polybutylene terephthalate, polyamides, polystyrene, polystyrene derivatives, polyphenylene oxide, polyoxymethylene, and fluorine-containing thermoplastics. Polyolefins are formed by polymerizing α-olefins such as, but not limited to, ethylene, propylene, 1-butene, 1-hexene, 1-octene, 2-methyl-1-propene, 3-methyl-1-pentene, 4-methyl-1-pentene, 5-methyl-1-hexene, and mixtures thereof. Copolymers of ethylene and propylene or ethylene or propylene with another α-olefin such as 1-butene, 1-hexene, 1-octene, 2-methyl-1-propene, 3-methyl-1-pentene, 4-methyl-1-pentene, 5-methyl-1-hexene or mixtures thereof are also contemplated. These homopolymers and copolymers, and blends of them, may be incorporated as the thermoplastic polymeric material of the embodiments.

The cured elastomeric polymeric material of the embodiments is based on the product of vulcanization or cure of elastomeric material that is well known in the art. Upon cure, the elastomeric materials become rubber-like in physical properties. For example, rubber-like materials are characterized by high levels of resilience, softness, and compression set. Many suitable elastomeric polymeric materials are known, which can be cured or vulcanized according to known procedures, such as described in the Encyclopedia of Polymer Science and Engineering, Volume 17 in the article entitled "Vulcanization". Preferred elastomers include those that are known to withstand high temperatures as well as provide adequate chemical resistance to fluids such as those found in automotive applications. Among preferred elastomers for use in the magnetizable composition embodiments are acrylic elastomers and ethylene acrylic elastomers.

Acrylic elastomers have the ASTM designation ACM for polymers of ethylacrylate and other acrylates, and ANM for copolymers of ethyl or other acrylates with acrylonitrile. Acrylic elastomers are prepared by polymerizing so-called backbone monomers with optionally a minor amount of cure site monomer. The backbone monomers are selected from among ethyl acrylate and other acrylic monomers. Other preferred acrylic acrylate monomers to be co-polymerized together with ethyl acrylate to make acrylic elastomers include n-butyl acrylate, 2-methoxyethyl acrylate, and 2-ethoxyethyl acrylate.

The acrylic elastomers (such as aforementioned Nypol™, Hytemp™, and Noxtite™) may contain from about 1 to about 5 mole % or weight % of cure site monomers to introduce reactive sites for subsequent crosslinking. The particular cure site monomer used in an acrylic elastomer is in general proprietary to the supplier of the elastomer. Among common cure site monomers are those that contain unsaturated carbon bonds and their side chain and those that contain a carbon-chlorine bond in the side chain.

Ethylene acrylic elastomers have the ASTM designation AEM. They are based on copolymers of ethylene and acrylate monomers, with a minor amount of cure site monomer, usually containing a carboxyl group in the side chain. Curing agents or crosslinking agents may then be used to cure or vulcanize the ethylene acrylic elastomer by reacting with the functional group in the cure site monomer. Although the precise nature of the crosslinking agent is proprietary to the supplier of the ethylene acrylic elastomers, two main classes of curing of vulcanization agents for use with such elastomers are the class of diamines and the class of peroxides. Diamines have the advantage that they cure slower but can be used at higher temperatures without scorch from too fast a cure. Mixtures of curing agents may be used, as is known to those of skill in the art, to obtain a desirable cure rate in light of the temperature conditions of the reaction. Ethylene acrylic elastomers are commercially available, including Vamac™ G (diamine cured elastomers), and Vamac™ D (peroxide cured elastomers).

To make the magnetizable composition embodiments, hard magnetic material is dispersed in a blend of an elastomeric material and a thermoplastic material prior to the onset of cure of the elastomeric material. Once the hard magnetic material is dispersed throughout both the thermoplastic phase and the uncured elastomeric phase, the elastomeric phase may be cured to provide the composition embodiments, preferably while maintaining mixing of the two phases.

Because the elastomeric material and thermoplastic material are to be melt blended, mixing necessarily occurs above the softening or melting point of the higher melting component. This higher melting component is usually the thermoplastic material. It may be that such a mixing temperature is above the temperature at which the curing agent reacts with the elastomeric material. If so, care must be taken to add the curing agent at a time after mixing such that both the magnetic material is dispersed into both the thermoplastic and elastomer phases on the one hand, and the elastomeric material is cured in the presence of the thermoplastic phase on the other hand. In this regard, it is preferred to use curing agents such as diamines that are not adversely affected by high temperatures such as would occur during the melt blending of a high melting thermoplastic material. With diamine curing agents, it is preferred to use crosslinking accelerators. Preferred accelerators include guanidine derivatives such as di-ortho-tolyl guanidine (DOTG).

In a preferred embodiment, magnetizable multiphase compositions are made by dynamically vulcanizing the elastomeric particles in the presence of the thermoplastic material, while continuing to mix or masticate the mixture. As noted above, the hard magnetic material may be added to either the thermoplastic material stream or the elastomer material stream or both.

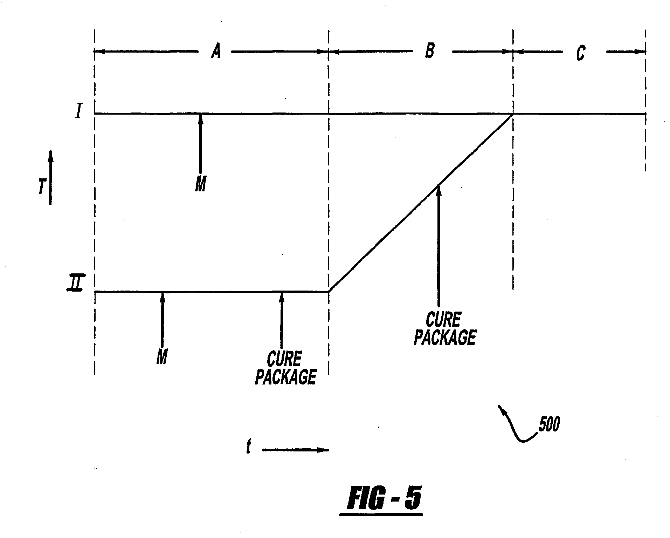

A non-limiting example of a setpoint temperature profile 500 (as a function of elapsed time) in a synthesis that may be used to form the compositional embodiments is set forth in Figure 5. Figure 5 show diagramatically the temperature versus time for a thermoplastic stream I and an elastomeric stream II. During time range A, the two streams are individually melt blended at temperatures sufficient to soften the polymeric material. Hard magnetic material may be added at this time to stream I, to stream I, or to both as indicated at M. A cure package may be added to stream II, either with, during, or after addition of the magnetic material. Other conventional additives and processing aids may also be added to streams I and II. During time range B, the temperature of stream II is ramped up to a higher temperature before being combined with stream I. This is usually preferred to avoid thermal shock to stream II and its curing package. As shown, the temperature of stream II is brought up to that of stream I before the streams are combined. Alternatively, the two streams may be combined at different temperatures. A curing package may be added to stream II during time range B.

Whether added in time range A, time range, or both, the cure package is added to stream II at a time sufficient to permit cure of the elastomer in stream II to a significant degree after the streams are combined. The process in Figure 5 is conveniently carried in a twin-screw extruder apparatus. In such an apparatus, the variable time corresponds roughly to the extruder path traveled by the streams. A continuous process may be developed by adjusting screw parameters, time, and temperature. Alternatively, the streams may be treated in separate mixers and combined at the times indicated in protocol 500 of Figure 5. In either case, it is preferred to apply mechanical energy, such as by agitating, stirring, mixing, milling, blending, etc., the combination of uncured elastomeric polymeric material, thermoplastic polymeric material, and hard magnetic material particles during the curing stage in time range C.

In a non-limiting example, a thermoplastic material is melted and stirred together with particles of a hard magnetic material. Separately, an elastomeric material is melted and optionally hard magnetic materials are added to the melted elastomeric material. In general, the thermoplastic melt is at a higher temperature than the elastomeric melt. In one embodiment, the melted stirred thermoplastic and elastomeric streams may be combined, such as in a twin screw extruder. Upon combining the thermoplastic stream and the elastomer stream, the phases continue to be mixed while a curative package is added. Conveniently, such addition can be made through a port in the twin screw extruder apparatus. Mixing is continued with the curing package for a time sufficient to partially or fully cure the elastomeric particles. In a twin screw extruder apparatus, the mixing and cure time may be conveniently adjusted by varying the length of the extruder path. The method just described will be suitable if the cure package can withstand being added to the stirred mixture at the higher temperature of the thermoplastic melt.

In another embodiment, it may be desirable to add a curative package to the elastomer stream before combining it with the thermoplastic stream. In such a case, the temperature of the elastomer stream may be ramped up at a desired rate until the curing package and elastomer mix (alternatively also including hard magnetic material particles) may be added to the thermoplastic stream with less thermal shock to the curative package. In this embodiment, it is preferred to combine the thermoplastic stream and elastomeric stream within a time after addition of the curative package to the elastomer stream that is less than the time at which the elastomer is significantly cured. As a rule of thumb, it is desired to mix the elastomer stream and thermoplastic stream within a time after addition of the curative that is less than the Ts2 of the elastomer. Ts2 is the time required, at a given temperature, for 2% cure to be completed.

In a preferred embodiment, the magnetizable compositions are incorporated into magnetic encoders, such as those used in the automotive and other industries as targets for magnetic wheel speed sensors. Encoders may be produced by a process including overmolding a magnetizable composition embodiment onto a metal case that has been pretreated with adhesive. The overmolding process may be accomplished by compression molding but would preferably be accomplished in an injection molding process. Alternatively, the encoder may be produced from the compositions in a bi-material molding process, where a different thermoplastic would be molded as a structural substrate for the magnetizable composition embodiments.

An example of an embodiment application for which the material compositional embodiments is used is a magnetic encoder for a wheel speed measuring system. Such a wheel speed measuring system has particular application in automobiles or in other systems having a need for measuring the speeds of components. An example of such an encoder is made with a previously described admixture over-molded onto a metal case pretreated with adhesive. Another example approach for making an encoder is to mold the admixture in a bi-material molding process, where a thermoplastic is molded as the structural substrate for the magnetizable TPE substance. The overmolding process is, in one embodiment, a compression-molding process, but, in an alternative embodiment, it is an injection-molding process.

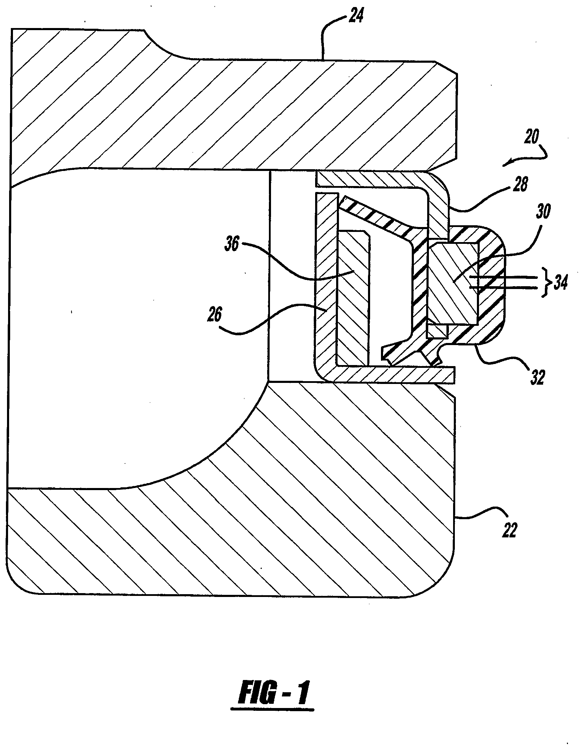

Examples of magnetic encoder assemblies and sensor target assemblies that advantageously employ the compositional embodiments are illustrated in Figs. 1 through 4. Encoder assembly 20, for use in a rotational speed sensing device, is illustrated in Fig. 1. Encoder assembly 20 is disposed between inner race 22 and outer race 24 of a bearing assembly. The bearing assembly may be, for example, a component of a vehicle wheel bearing assembly wherein outer race 24 is attached to a vehicle frame (or other component that is rotationally fixed relative to a vehicle frame) and inner race 22 is rotationally affixed to the vehicle's wheel. As should be appreciated by those of skill, such a magnetic encoder assembly may also be employed with other types of rotary shafts in order to sense speed and/or rotational position of a shaft relative to a fixed body.

Encoder assembly 20 includes first support member 26, which is rotationally fixed to inner race 22, and second support member 28, which is rotationally fixed to outer race 24. First and second support members 26, 28 are preferably stainless steel, but alternatively are made of other suitable materials, such as thermoplastic or thermoset plastic material. Second support member 28 retains and supports rotation sensing device 30 and elastomeric seal 32 as preferably molded around sensing device 30 and sensor leads 34 protruding therefrom. Rotation sensing device 30 is, for example, a Hall-effect sensor; in an alternative embodiment, device 30 is a magneto-resistance device.

Multi-pole ring member 36 (also known as a target wheel) is mounted to first support member 26. Multi-pole ring member 36 has a surface facing rotation sensing device 30 and spaced a predetermined distance therefrom. Multi-pole ring member 36 is made of magnetizable thermoplastic elastomer admixture as described above. Multi-pole ring member 36 is preferably formed employing the previously discussed techniques associated with processing TPE materials, such as, for example, a continuous compounding via twin screw extrusion, cutting of the extrudate into small pellets, and fabrication with standard thermoplastic processing equipment. Ring member 36 then is magnetized so that magnetizable material is provided in alternating north and south poles in the circumferential direction of ring member 36. In operation, as inner race 22 rotates relative to outer race 24, these poles move alternately past rotation sensing device 30 and create a changing magnetic field for sensing by device 30.

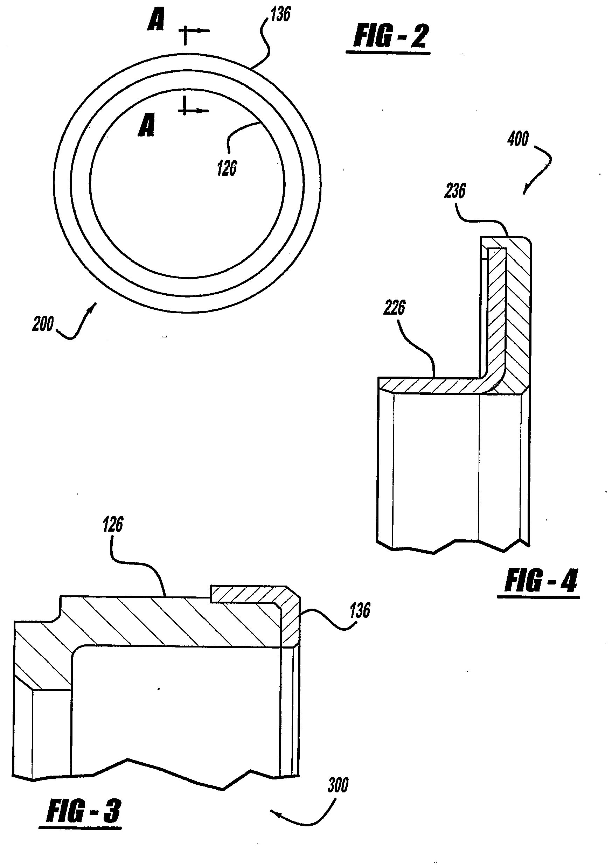

Figs. 2 and 3 show a sensor target assembly 200 (Fig. 3 providing assembly view 300 into cross section A-A of Fig. 2) with encoder 136 mounted to support 126. Encoder 136 is preferably formed of a magnetizable thermoplastic elastomer admixture embodiment as described above.

Fig. 4 shows a sensor target assembly 400 of encoder 236 secured to support 226. Again, encoder 236 is preferably formed of magnetizable thermoplastic elastomer admixture as described above.

### EXAMPLES

Examples 1 and 2: Examples of two compositions of ethylene acrylic elastomers thermoset elastomer (Vamac™) and ferrite powder in Hytrel™ thermoplastic polyester elastomer (Examples 1 as Admixture A and Example 2 as Admixture B) are presented in Table 1 and heat aging properties of these two compositions are further shown in Tables 2 and 3 to further illustrate specific embodiments.

**Table 1**

| Composition of Two Magnetizable Thermoplastic Elastomer Admixtures | | | | | |
|---|---|---|---|---|---|
| Component | Density | Admixture A | | Admixture B | |
| | g/cc | wt% | vol% | wt% | vol% |
| Hytrel™ HTR 8139BK | 1.15 | 14.3 | 37.4 | 13.5 | 32.1 |
| Ferrite HM 1701 | 5.07 | 80.8 | 48.0 | 76.5 | 41.3 |
| Vamac™ G | 1.03 | 05.0 | 14.6 | 10.0 | 26.6 |

**Table 2**

| Heat Aging Properties of Magnetizable Thermoplastic | | |
|---|---|---|
| Elastomer Admixtures at 125 Degrees C in Air | | |
| AGE TIME / Property | Admixture A | Admixture B |
| | | |
| ORIGINAL PROPERTIES | | |
| Tensile Strength MPa | 12.4 | 8.2 |
| 50% Modulus Mpa | - | 7.7 |
| Elongation % | 27 | 69 |
| Hardness, Shore A, pts | 92 | 89 |
| Hardness, Shore D, pts | 59 | 46 |
| Specific Gravity | 2.99 | 2.77 |
| | | |

| 70 HOURS | | |
|---|---|---|
| Tensile Strength MPa | 13.5 | 9.5 |
| 50% Modulus MPa | - | 9.1 |
| Elongation % | 46 | 116 |
| Hardness, Shore A, pts | 99 | 97 |
| Hardness, Shore D, pts | 60 | 50 |
| Surface Appearance | Good | Good |
| | | |

| 168 HOURS | | |
|---|---|---|
| Tensile Strength MPa | 12.9 | 10.1 |
| 50% Modulus MPa | - | 9.5 |
| Elongation % | 25 | 94 |
| Hardness, Shore A, pts | 101 | 96 |
| Hardness, Shore D, pts | 62 | 50 |
| Surface Appearance | Poor | Good |
| | | |

| 336 HOURS | | |
|---|---|---|
| Tensile Strength MPa | 14.2 | 10.3 |
| 50% Modulus MPa | - | 9.7 |
| Elongation % | 43 | 86 |
| Hardness, Shore A, pts | 100 | 95 |
| Hardness, Shore D, pts | 64 | 51 |
| Surface Appearance | Poor | Good |
| | | |

| 504 HOURS | | |
|---|---|---|
| Tensile Strength MPa | 13.8 | 10.5 |
| 50% Modulus MPa | - | 9.5 |
| Elongation % | 33 | 109 |
| Hardness, Shore A, pts | 101 | 96 |
| Hardness, Shore D, pts | 61 | 50 |
| Surface Appearance | Good | Good |

Note that the elongation increases and the hardness decreases as with the level of VamacTM ethylene acrylic elastomer (AEM) in the admixture. Table 3 shows the percentage change in the heat aging properties of Table 2 (the percentage change is always with respect to the original property value before heat aging commenced). As shown in both tables 2 and 3, heat aging generally positively enhances admixture properties.

**Table 3**

| Percentage Change In Heat Aging Properties of Magnetizable | | |
|---|---|---|
| Thermoplastic Elastomer Admixtures at 125 Degrees C in Air | | |
| AGE TIME / Property | Admixture A | Admixture B |
| | | |
| 70 HOURS | | |
| Percentage Change in Tensile Strength | 9 | 16 |
| Percentage Change in 50% Modulus | - | 18 |
| Percentage Change in Elongation | 70 | 68 |
| Percentage Change in Hardness, Shore A | 7 | 8 |
| Percentage Change in Hardness, Shore D | 1 | 4 |
| | | |

| 168 HOURS | | |
|---|---|---|
| Percentage Change in Tensile Strength | 4 | 23 |
| Percentage Change in 50% Modulus | - | 24 |
| Percentage Change in Elongation | -7 | 37 |
| Percentage Change in Hardness, Shore A | 9 | 7 |
| Percentage Change in Hardness, Shore D | 3 | 4 |
| | | |

| 336 HOURS | | |
|---|---|---|
| Percentage Change in Tensile Strength | 15 | 26 |
| Percentage Change in 50% Modulus | - | 26 |
| Percentage Change in Elongation | 59 | 25 |
| Percentage Change in Hardness, Shore A | 8 | 6 |
| Percentage Change in Hardness, Shore D | 5 | 5 |
| | | |

| 504 HOURS | | |
|---|---|---|
| Percentage Change in Tensile Strength | 11 | 28 |
| Percentage Change in 50% Modulus | - | 24 |
| Percentage Change in Elongation | 22 | 58 |
| Percentage Change in Hardness, Shore A | 9 | 7 |
| Percentage Change in Hardness, Shore D | 2 | 4 |

Examples 3 and 4: Magnetizable composition example embodiments are prepared according to the recipes given in Example 3 and Example 4. The weight percents and volume percents given in Examples 3 and 4 are the percentages in the final magnetizable composition. In Examples 3 and 4, half of the ferrite material is combined with the polyester elastomer and half is combined with the ethylene acrylic elastomer in separate streams. The streams are melted and stirred together with the ferrite material. The mixing streams are combined in a twin screw extruder, followed by addition of a diamine curative package for the ethylene acrylic elastomer. After further mixing for a time sufficient to cure the Vamac™ G material, the magnetizable composition is removed from the twin screw extruder. The material from the extruder is combined with carbon black and optional other processing aids and molded into a disc shaped or annulus shaped ring. The disc or annulus is magnetized according to known procedures to produce an encoder elastomer for use in the embodiments.

| | **Density** | **Example 3** | | **Example 4** | |
|---|---|---|---|---|---|
| | **g/cc** | **wt %** | **vol %** | **wt %** | **vol %** |
| Polyester Elastomer | 1.115 | 14.3 | 37.4 | 13.5 | 32.1 |
| Sr-Ba Ferrite | 5.07 | 80.8 | 48.0 | 76.5 | 41.3 |
| Acrylic Elastomer | 1.03 | 5.0 | 14.6 | 10.0 | 26.6 |
| Total | | 100.0 | 100.0 | 100.0 | 100.0 |

Examples 5 and 6: Examples 5 and 6 give the recipes for forming magnetizable composition example embodiments using diamine curing agents and accelerators. The mixing of separate streams, heating, temperature ramping, combining, and mixing can be readily accomplished using a twin screw extruder apparatus. The ferrite and polyester elastomer are combined in a first thermoplastic stream and melt blended. In a separate stream, the acrylic elastomer, curing accelerator, and diamine curing agent are melt blended at a temperature of about 100oC or lower. This temperature is lower than the activation temperature of the crosslinking so that no significant crosslinking occurs in the elastomeric stream. The thermoplastic stream is stirred at a temperature of about 200oC, which is sufficient to soften or melt the polyester elastomer. To avoid thermal shock to the curing agent and accelerator, the elastomer stream is ramped up in temperature prior to being combined with the thermoplastic stream at 200oC. The ramp-up speed of the temperature of the elastomeric stream is chosen such that by the time the temperature reaches 200oC and the elastomeric stream is combined with the thermoplastic stream, the acrylic elastomer is not significantly cured or vulcanized. Once the thermoplastic stream and elastomeric stream are combined, the streams are mixed for a further period sufficient to partially or completely cure or vulcanize the acrylic elastomer. The composition is then removed, where it can be further processed on standard thermoplastic processing equipment.

| | | **Example 5** | | | | **Example 6** | | | |
|---|---|---|---|---|---|---|---|---|---|
| | **Density G/cc** | **Charge g** | **Charge cc** | **Wt. %** | **Vol. %** | **Charge G** | **Charge Cc** | **Wt. %** | **Vol. %** |
| Polyester Elastomer | 1.15 | 10.7 | 8.76 | 10.1 | 27.2 | | 6.91 | 7.9 | 23.4 |
| Sr-Ba Ferrite | 5.11 | 82.35 | 16.12 | 82.3 | 50.0 | 86.08 | 16.85 | 86.1 | 57.0 |
| Acrylic Elastomer | 1.03 | 7.55 | 7.33 | 7.55 | 22.74 | 5.96 | 5.78 | 6.0 | 19.6 |
| Curing Accelerator | 1.10 | 0.023 | 0.021 | 0.023 | .064 | 0.018 | 0.016 | .018 | .055 |
| Diamine Curing Agent | 1.28 | 0.008 | 0.006 | .008 | .018 | 0.006 | 0.005 | .006 | .016 |
| **Total** | | **100.00** | **32.23** | **100.0%** | **100.0%** | **100.00** | **29.55** | **100.00** | **29.55** |

In an alternative process, the strontium barium ferrite may be divided among the thermoplastic stream and elastomer stream prior to mixing the streams. Although the ferrite may be distributed between the two streams in any fashion, it is preferred that both streams contain an equal weight percent or volume percent of the ferrite. In general, it is believed that such will further enable an even distribution of ferrite particles in the thermoplastic phase and in the elastomeric phase of the magnetizable composition formed in the twin screw process.

The process of making the compositional embodiments, in which magnetic material is incorporated into a blend of thermoplastic material and elastomeric material prior to curing the elastomer, provides both thermoplastic and thermoset phases of the blended material as carriers for the magnetic materials. This allows for high volume matrix loadings of magnetic material even as desired material properties are achieved. In this regard, an advantage of the embodiments is that a material is provided which combines (a) mechanical and environmental durability advantages of thermoset-elastomer-based magnetic compounds under the range of environmental conditions needed for vehicle encoder applications with (b) ease of processing and manufacturing offered by engineered thermoplastics.

The examples and other embodiments described herein are exemplary and not intended to be limiting in describing the full scope of compositions and methods of this invention. Equivalent changes, modifications and variations of specific embodiments, materials, compositions and methods may be made within the scope of the present invention, with substantially similar results.

## Claims

1. A magnetizable thermoplastic elastomer composition comprising an admixture of thermoplastic polymer, elastomeric polymer, and magnetizable powder, wherein said thermoplastic polymer is thermoplastic elastomer and said elastomeric polymer is a thermoset elastomer.

2. A magnetizable thermoplastic elastomer composition according to Claim 1, wherein said thermoplastic polymer provides a first phase in said composition, said elastomeric polymer provides a second phase in said composition, and said magnetizable powder is dispersed In said first phase and In said second phase.

3. A composition according to either of Claims 1 or 2, wherein said elastomeric polymer is either fully cured or partially cured.

4. A magnetizable thermoplastic elastomer composition according to either of Claims 1 or 2, wherein the thermoset elastomer is an elastomer that has not been subjected to vulcanization.

5. A magnetizable thermoplastic elastomer composition according to Claim 4, wherein the elastomeric polymer is selected from the group consisting of ethylene acrylic elastomers, acrylate elastomers, cross-linking monomer elastomers, and mixtures thereof.

6. A magnetizable thermoplastic elastomer composition of any of Claims 1 through 5, wherein the thermoplastic elastomer Is from 5% to 50% (by weight) of the composition.

7. A magnetizable thermoplastic elastomer composition according to any of Claims 1 through 6, wherein the elastomeric polymer is from 3% to 40% (by weight) of the composition.

8. A magnetizable thermoplastic elastomer composition according to any of Claims 1 through 7, wherein the magnetizable powder is from 1% to 90% (by weight) of the composition.

9. A magnetizable thermoplastic elastomer composition according to Claim 8, wherein the magnetizable powder is selected from the group consisting of strontium ferrite oxide, barium ferrite oxide, ferrite alloys containing aluminum and nickel and cobalt, rare-earth ferrites, and mixtures thereof.

10. A magnetizable thermoplastic elastomer composition according to any of Claims 1 through 9, wherein the thermoplastic elastomer is a thermoplastic polyester elastomer.

11. A target wheel for use in an encoder, the target wheel comprising a generally disk shaped member comprising a magnetizable thermoplastic elastomer composition according any of Claims 1 to 10.

12. An encoder, preferably a radial encoder or axial encoder, comprising:
(a) a magnetic sensor adapted to detect changes in an adjacent magnetic field; and
(b) a target wheel of claim 11, the target wheel having a surface adjacent the magnetic sensor and movable relative thereto, said target wheel magnetized to provide alternating magnetic polarity along said surface and, in operation, said magnetic field changes thereby.

13. An encoder according to Claim 12, wherein the magnetic sensor is adapted for attachment to one of a wheel and a vehicle body in a vehicle, and the target wheel is adapted for attachment to the other of the wheel and the vehicle body.

14. A method of making a magnetizable thermoplastic elastomer composition, said method comprising:
(a) admixing the thermoplastic polymer, elastomeric polymer, and magnetizable powder of a composition according to of any of Claims 1 through 3; and
(b) dynamically curing or vulcanizing said composition to cure said elastomeric polymer.

15. A method of making a target wheel for a rotational encoder, comprising:
(a) admixing the thermoplastic polymer, elastomeric polymer, and magnetizable powder of a composition according to any of Claims 1 through 10;
(b) molding said admixture into a target wheel; and
(c) magnetizing said target wheel to provide alternating magnetic polarity along a surface of said target wheel which in rotational operation will provide a changing magnetic field for sensing by a sensor.

16. A method of making a target wheel for a rotational encoder, comprising:
(a) admixing the thermoplastic polymer, elastomeric polymer, and magnetizable powder of a composition according to any of Claims 1 through 10;
(b) molding a thermoplastic as a structural substrate for said target wheel;
(c) over-molding said admixture onto said structural substrate; and
(d) magnetizing said target wheel to provide alternating magnetic polarity along a surface of said target wheel which in rotational operation will provide a changing magnetic field for sensing by a sensor.

17. A method according to any of Claims 14 or 15, further comprising (e) heat-aging said target wheel.

18. A method according to any of Claims 14 through 17, wherein said molding is achieved with either of a compression-molding process or an injection molding process.

19. A shaped article comprising a composition according to any of Claims 1 through 10.

20. A method of determining the rotational speed of a rotating member, comprising sensing a magnetic field in a target comprising a magnetizable substance and affixed to said rotating member, wherein said magnetizable substance is part of a composition according to any of Claims 1 to 10.

21. A process for making a magnetizable thermoplastic elastomer composition of which is a magnetizable powder, any of claims 1 to 10, the method comprising: (a) dispersing a hard magnetic material, which is a magnetizable powder, in a blend of the thermoplastic polymeric material and the elastomeric polymeric material; and (b) curing said elastomeric material in the presence of said thermoplastic material and said hard magnetic materials.

22. A process according to Claim 21, wherein said dispersing comprises:
(1) combining the thermoplastic polymeric material, the uncured elastomeric polymeric material, and particles of hard magnetic material to form a combination, wherein said hard magnetic material comprises from 10 percent to 90 percent by volume of said combination; and
(2) applying mechanical energy to said combination to form said blend; and wherein said curing further comprises continuing to apply mechanical energy during said curing.

23. A process according to either of Claims 21 or 22, further comprising dynamically vulcanizing said elastomeric material during said dispersing of said thermoplastic material and said hard magnetic material.

24. A process according to any of Claims 21 to 23, carried out in a twin-screw extrusion apparatus.

25. A process according to any of Claims 21 to 24, wherein said composition comprises from about 10 to about 300 parts of said elastomeric material per 100 parts of thermoplastic material.

26. A process according to Claim 25, wherein said composition comprises from 25 to 100 parts of said elastomeric material per 100 parts of thermoplastic material.

27. A process according to any of Claims 21 through 26, wherein said elastomeric material is selected from the group consisting of acrylic elastomers, ethylene acrylic elastomers, and mixtures thereof.

## Patentansprüche

1. Magnetisierbare thermoplastische Elastomerzusammensetzung, umfassend eine Beimischung von thermoplastischem Polymer, elastomerem Polymer und magnetisierbarem Pulver, wobei das thermoplastische Polymer thermoplastisches Elastomer ist und das elastomere Polymer ein duroplastisches Elastomer ist.

2. Magnetisierbare thermoplastische Elastomerzusammensetzung nach Anspruch 1, wobei das thermoplastische Polymer eine erste Phase in der Zusammensetzung bereitstellt, wobei das elastomere Polymer eine zweite Phase in der Zusammensetzung bereitstellt und das magnetisierbare Pulver in der ersten Phase und in der zweiten Phase dispergiert ist.

3. Zusammensetzung nach einem der Ansprüche 1 oder 2, wobei das elastomere Polymer entweder vollständig gehärtet oder teilweise gehärtet ist.

4. Magnetisierbare thermoplastische Elastomerzusammensetzung nach einem der Ansprüche 1 oder 2, wobei das duroplastische Elastomer ein Elastomer ist, das nicht einer Vulkanisation unterzogen wurde.

5. Magnetisierbare thermoplastische Elastomerzusammensetzung nach Anspruch 4, wobei das elastomere Polymer ausgewählt ist aus der Gruppe, bestehend aus Ethylen-Acryl-Elastomeren, Acrylat-Elastomeren, vernetzenden Monomer-Elastomeren und Mischungen davon.

6. Magnetisierbare thermoplastische Elastomerzusammensetzung nach einem der Ansprüche 1 bis 5, wobei das thermoplastische Elastomer 5 bis 50 Gew.-% der Zusammensetzung beträgt.

7. Magnetisierbare thermoplastische Elastomerzusammensetzung nach einem der Ansprüche 1 bis 6, wobei das thermoplastische Elastomer 3 bis 40 Gew.-% der Zusammensetzung beträgt.

8. Magnetisierbare thermoplastische Elastomerzusammensetzung nach einem der Ansprüche 1 bis 7, wobei das magnetisierbare Pulver von 1 bis 90 Gew.-% der Zusammensetzung beträgt.

9. Magnetisierbare thermoplastische Elastomerzusammensetzung nach Anspruch 8, wobei das magnetisierbare Pulver ausgewählt ist aus der Gruppe, bestehend aus Strontiumferritoxid, Bariumferritoxid, Ferritlegierungen, die Aluminium und Nickel und Kobalt, Seltenerdferrite und Mischungen davon enthalten.

10. Magnetisierbare thermoplastische Elastomerzusammensetzung nach einem der Ansprüche 1 bis 9, wobei das thermoplastische Elastomer ein thermoplastisches Polyesterelastomer ist.

11. Zielrad zur Verwendung in einem Codierer, wobei das Zielrad ein allgemein scheibenförmiges Element umfasst, das eine magnetisierbare thermoplastische Elastomerzusammensetzung nach einem der Ansprüche 1 bis 10 umfasst.

12. Codierer, vorzugsweise ein Radialcodierer oder ein Axialcodierer, umfassend:
(a) einen magnetischen Sensor, der ausgelegt ist, um Änderungen in einem benachbarten Magnetfeld zu erfassen; und
(b) ein Zielrad nach Anspruch 11, wobei das Zielrad eine Oberfläche aufweist, die an den magnetischen Sensor angrenzt und relativ zu diesem beweglich ist, wobei das Zielrad magnetisiert ist, um im Gebrauch eine wechselnde magnetische Polarität entlang der Oberfläche bereitzustellen, wodurch sich das Magnetfeld ändert.

13. Codierer nach Anspruch 12, wobei der magnetische Sensor zur Befestigung entweder an einem Rad oder einer Fahrzeugkarosserie in einem Fahrzeug ausgelegt ist und das Zielrad zur Befestigung an dem anderen von Rad und Fahrzeugkarosserie ausgelegt ist.

14. Verfahren zur Herstellung einer magnetisierbaren thermoplastischen Elastomerzusammensetzung, wobei das Verfahren umfasst:
(a) Beimischen des thermoplastischen Polymers, des elastomeren Polymers und des magnetisierbaren Pulvers einer Zusammensetzung nach einem der Ansprüche 1 bis 3; und
(b) dynamisches Härten oder Vulkanisieren der Zusammensetzung zum Härten des elastomeren Polymers.

15. Verfahren zur Herstellung eines Zielrades für einen Rotationscodierer, umfassend:
(a) Beimischen des thermoplastischen Polymers, des elastomeren Polymers und des magnetisierbaren Pulvers einer Zusammensetzung nach einem der Ansprüche 1 bis 10;
(b) Formen der Beimischung in einem Zielrad; und
(c) Magnetisieren des Zielrads, um eine wechselnde magnetische Polarität entlang einer Oberfläche des Zielrads bereitzustellen, die im Rotationsbetrieb ein sich änderndes Magnetfeld zum Erfassen durch einen Sensor bereitstellt.

16. Verfahren zur Herstellung eines Zielrades für einen Rotationscodierer, umfassend:
(a) Beimischen des thermoplastischen Polymers, des elastomeren Polymers und des magnetisierbaren Pulvers einer Zusammensetzung nach einem der Ansprüche 1 bis 10;
(b) Formen eines Thermoplasten als strukturelles Substrat für das Zielrad;
(c) Überformen der Beimischung über das strukturelle Substrat; und
(d) Magnetisieren des Zielrads, um eine wechselnde magnetische Polarität entlang einer Oberfläche des Zielrads bereitzustellen, die im Rotationsbetrieb ein sich änderndes Magnetfeld zum Erfassen durch einen Sensor bereitstellt.

17. Verfahren nach einem der Ansprüche 14 oder 15, ferner umfassend:
(e) Wärmealterung des Zielrades.

18. Verfahren nach einem der Ansprüche 14 bis 17, wobei das Formen entweder mit einem Kompressionsformverfahren oder einem Spritzgussverfahren erreicht wird.

19. Geformter Artikel, umfassend die Zusammensetzung nach einem der Ansprüche 1 bis 10.

20. Verfahren zum Bestimmen der Rotationsgeschwindigkeit eines rotierenden Elements, umfassend das Erfassen eines Magnetfeldes in einem Ziel, das eine magnetisierbare Substanz umfasst und an dem rotierenden Element befestigt ist, wobei die magnetisierbare Substanz Teil einer Zusammensetzung nach einem der Ansprüche 1 bis 10 ist.

21. Prozess zur Herstellung einer magnetisierbaren thermoplastischen Elastomerzusammensetzung nach einem der Ansprüche 1 bis 10, wobei das Verfahren umfasst:
(a) Dispergieren eines magnetischen Hartmaterials, das ein magnetisierbares Pulver in einer Mischung aus dem thermoplastischen Polymermaterial und dem elastomeren Polymermaterial ist; und
(b) Härten des elastomeren Materials in Gegenwart des thermoplastischen Materials und des magnetischen Hartmaterials.

22. Verfahren nach Anspruch 21, wobei das Dispergieren umfasst:
(1) Kombinieren des thermoplastischen Polymermaterials und des ungehärteten elastomeren Polymermaterials und Teilchen aus magnetischem Hartmaterial, um eine Kombination zu bilden, wobei das magnetische Hartmaterial etwa 10 bis etwa 90 Volumenprozent der Kombination umfasst; und
(2) Anlegen von mechanischer Energie an die Kombination, um die Mischung zu bilden; und wobei das Härten ferner das Fortsetzen der mechanischen Energie während des Härtens umfasst.

23. Prozess nach einem der Ansprüche 21 oder 22, ferner umfassend das dynamische Vulkanisieren des elastomeren Materials während des Dispergierens des thermoplastischen Materials und des magnetischen Hartmaterials.

24. Prozess nach einem der Ansprüche 21 bis 23, das in einer Doppelschneckenextrusionsvorrichtung ausgeführt wird.

25. Verfahren nach einem der Ansprüche 21 bis 24, wobei die Zusammensetzung etwa 10 bis etwa 300 Teile des elastomeren Materials pro 100 Teile thermoplastisches Material umfasst.

26. Verfahren nach Anspruch 25, wobei die Zusammensetzung etwa 25 bis etwa 100 Teile des elastomeren Materials pro 100 Teile thermoplastisches Material umfasst.

27. Verfahren nach einem der Ansprüche 21 bis 26, wobei das elastomere Material ausgewählt ist aus der Gruppe, bestehend aus Acryl-Elastomeren, Ethylen-Acryl-Elastomeren und Mischungen davon.

## Revendications

1. Composition d'élastomère thermoplastique aimantable comprenant un mélange de polymère thermoplastique, de polymère élastomère et de poudre aimantable, ledit polymère thermoplastique étant un élastomère thermoplastique et ledit polymère élastomère étant un élastomère thermodurci.

2. Composition d'élastomère thermoplastique aimantable selon la revendication 1, ledit polymère thermoplastique fournissant une première phase dans ladite composition, ledit polymère élastomère fournissant une deuxième phase dans ladite composition, et ladite poudre aimantable étant dispersée dans ladite première phase et dans ladite deuxième phase.

3. Composition selon l'une ou l'autre des revendications 1 ou 2, dans laquelle ledit polymère élastomère est totalement durci ou partiellement durci.

4. Composition d'élastomère thermoplastique aimantable selon l'une ou l'autre des revendications 1 ou 2, dans laquelle l'élastomère thermodurci est un élastomère qui n'a pas été soumis à une vulcanisation.

5. Composition d'élastomère thermoplastique aimantable selon la revendication 4, dans laquelle le polymère élastomère est choisi dans le groupe constitué par les élastomères acryliques d'éthylène, les élastomères d'acrylate, les élastomères à monomères de réticulation, et les mélanges de ceux-ci.

6. Composition d'élastomère thermoplastique aimantable de l'une quelconque des revendications 1 à 5, l'élastomère thermoplastique représentant de 5 % à 50 % (en poids) de la composition.

7. Composition d'élastomère thermoplastique aimantable selon l'une quelconque des revendications 1 à 6, le polymère élastomère représentant de 3 % à 40 % (en poids) de la composition.

8. Composition d'élastomère thermoplastique aimantable selon l'une quelconque des revendications 1 à 7, la poudre aimantable représentant de 1 % à 90 % (en poids) de la composition.

9. Composition d'élastomère thermoplastique aimantable selon la revendication 8, dans laquelle la poudre aimantable est choisie dans le groupe constitué par l'oxyde ferrite de strontium, l'oxyde ferrite de baryum, les alliages de ferrite contenant de l'aluminium et du nickel et du cobalt, les ferrites de terres rares, et les mélanges de ceux-ci.

10. Composition d'élastomère thermoplastique aimantable selon l'une quelconque des revendications 1 à 9, dans laquelle l'élastomère thermoplastique est un élastomère de polyester thermoplastique.

11. Roue cible pour utilisation dans un codeur, la roue cible comprenant un élément généralement en forme de disque comprenant une composition d'élastomère thermoplastique aimantable selon l'une quelconque des revendications 1 à 10.

12. Codeur, de préférence un codeur radial ou un codeur axial, comprenant :
(a) un capteur magnétique adapté pour détecter des variations dans un champ magnétique adjacent ; et
(b) une roue cible de la revendication 11, la roue cible ayant une surface adjacente au capteur magnétique et mobile par rapport à celui-ci, ladite roue cible aimantée pour fournir une polarité magnétique alternative le long de ladite surface et, en fonctionnement, ledit champ magnétique varie en conséquence.

13. Codeur selon la revendication 12, dans lequel le capteur magnétique est adapté pour être fixé à un élément entre une roue et une carrosserie de véhicule dans un véhicule, et la roue cible est adaptée pour être fixée à l'autre élément entre la roue et la carrosserie de véhicule.

14. Procédé de préparation d'une composition d'élastomère thermoplastique aimantable, ledit procédé comprenant :
(a) le mélange du polymère thermoplastique, du polymère élastomère et de la poudre aimantable d'une composition selon l'une quelconque des revendications 1 à 3 ; et
(b) le durcissement ou la vulcanisation dynamiques de ladite composition pour durcir ledit polymère élastomère.

15. Procédé de fabrication d'une roue cible pour un codeur rotatif, comprenant :
(a) le mélange du polymère thermoplastique, du polymère élastomère et de la poudre aimantable d'une composition selon l'une quelconque des revendications 1 à 10 ;
(b) le moulage dudit mélange en une roue cible ; et
(c) l'aimantation de ladite roue cible pour fournir une polarité magnétique alternative le long d'une surface de ladite roue cible qui en fonctionnement rotatif fournira un champ magnétique variable pour détection par un capteur.

16. Procédé de fabrication d'une roue cible pour un codeur rotatif, comprenant :
(a) le mélange du polymère thermoplastique, du polymère élastomère et de la poudre aimantable d'une composition selon l'une quelconque des revendications 1 à 10 ;
(b) le moulage d'un thermoplastique comme substrat structural pour ladite roue cible ;
(c) le surmoulage dudit mélange sur ledit substrat structural ; et
(d) l'aimantation de ladite roue cible pour fournir une polarité magnétique alternative le long d'une surface de ladite roue cible qui en fonctionnement rotatif fournira un champ magnétique variable pour détection par un capteur.

17. Procédé selon l'une quelconque des revendications 14 ou 15, comprenant en outre
(e) le vieillissement thermique de ladite roue cible.

18. Procédé selon l'une quelconque des revendications 14 à 17, dans lequel ledit moulage est réalisé indifféremment avec un procédé de moulage par compression ou un procédé de moulage par injection.

19. Article façonné comprenant une composition selon l'une quelconque des revendications 1 à 10.

20. Procédé de détermination de la vitesse de rotation d'un élément rotatif, comprenant la détection d'un champ magnétique dans une cible comprenant une substance aimantable et fixée audit élément rotatif, ladite substance aimantable faisant partie d'une composition selon l'une quelconque des revendications 1 à 10.

21. Procédé de préparation d'une composition d'élastomère thermoplastique aimantable de l'une quelconque des revendications 1 à 10, le procédé comprenant : (a) la dispersion d'un matériau magnétique dur, qui est une poudre aimantable, dans un mélange du matériau polymère thermoplastique et du matériau polymère élastomère ; et (b) le durcissement dudit matériau élastomère en présence dudit matériau thermoplastique et dudit matériau magnétique dur.

22. Procédé selon la revendication 21, dans lequel ladite dispersion comprend :
(1) la combinaison du matériau polymère thermoplastique, du matériau polymère élastomère non durci et de particules de matériau magnétique dur pour former une combinaison, ledit matériau magnétique dur constituant 10 pour cent à 90 pour cent en volume de ladite combinaison ; et
(2) l'application d'énergie mécanique à ladite combinaison pour former ledit mélange ; et
dans lequel ledit durcissement comprend en outre la poursuite de l'application d'énergie mécanique pendant ledit durcissement.

23. Procédé selon l'une ou l'autre des revendications 21 ou 22, comprenant en outre la vulcanisation dynamique dudit matériau élastomère pendant ladite dispersion dudit matériau thermoplastique et dudit matériau magnétique dur.

24. Procédé selon l'une quelconque des revendications 21 à 23, réalisé dans un appareil d'extrusion à double vis.

25. Procédé selon l'une quelconque des revendications 21 à 24, dans lequel ladite composition comprend 10 à 300 parties dudit matériau élastomère pour 100 parties de matériau thermoplastique.

26. Procédé selon la revendication 25, dans lequel ladite composition comprend 25 à 100 parties dudit matériau élastomère pour 100 parties de matériau thermoplastique.

27. Procédé selon l'une quelconque des revendications 21 à 26, dans lequel ledit matériau élastomère est choisi dans le groupe constitué par les élastomères acryliques, les élastomères acryliques d'éthylène, et les mélanges de ceux-ci.
